(19) Europäisches Patentamt
European Patent Office
Office européen des brevets

(11) **EP 4 292 693 B1**

(12) **EUROPEAN PATENT SPECIFICATION**

(45) Date of publication and mention
of the grant of the patent:
**12.02.2025   Bulletin 2025/07**

(51) International Patent Classification (IPC):
**B01D 53/32** (2006.01)     **B01D 53/34** (2006.01)
**B01D 53/68** (2006.01)     **B01D 53/77** (2006.01)
**H01J 37/32** (2006.01)     **H05H 1/34** (2006.01)

(21) Application number: **22197267.2**

(22) Date of filing: **23.09.2022**

(52) Cooperative Patent Classification (CPC):
**B01D 53/346; B01D 53/32; B01D 53/68;**
**B01D 53/77; H01J 37/32027;** B01D 2251/202;
B01D 2257/204; B01D 2257/30; H05H 1/34;
H05H 2245/10; Y02C 20/30

(54) **SULFUR HEXAFLUORIDE DEGRADING DEVICE BASED ON THERMAL PLASMA**

SCHWEFELHEXAFLUORID-ABBAUVORRICHTUNG AUF BASIS EINES THERMISCHEN
PLASMAS

DISPOSITIF DE DÉGRADATION D'HEXAFLUORURE DE SOUFRE BASÉ SUR UN PLASMA
THERMIQUE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **16.06.2022   CN 202210694594**

(43) Date of publication of application:
**20.12.2023   Bulletin 2023/51**

(73) Proprietor: **Xi'an Jiaotong University**
**Xi'an, Shaanxi 710049 (CN)**

(72) Inventors:
• **Wu, Yi**
  **Xi'an, 710049 (CN)**
• **Sun, Hao**
  **Xi'an, 710049 (CN)**
• **Rong, Mingzhe**
  **Xi'an, 710049 (CN)**
• **Long, Hu**
  **Xi'an, 710049 (CN)**
• **Guo, Yunshun**
  **Xi'an, 710049 (CN)**

(74) Representative: **Huang, Liwei**
**Cäcilienstraße 12**
**40597 Düsseldorf (DE)**

(56) References cited:
EP-A1- 3 821 969     CN-A- 111 140 856
US-A- 5 965 786     US-A1- 2002 070 669
US-A1- 2007 235 339

## Description

## TECHNICAL FIELD

The present invention belongs to the technical field of gas degradation, in particular to a sulfur hexafluoride ($SF_6$) degrading device based on thermal plasma.

## BACKGROUND

$SF_6$ gas has been widely used since its inception due to its stable physical and chemical properties and excellent electrical properties. However, due to its extremely strong greenhouse effect, a Global Warming Potential (GWP) value is 23500. However, $SF_6$ is still widely used in a power system since no suitable high-performance substitute gas has been found. At the same time, due to extremely high self-recovery properties, it is difficult to completely degrade $SF_6$. Therefore, a method capable of efficiently degrading $SF_6$ is of a great significance.

In recent years, a plasma waste gas treatment technology has been widely studied. Compared with traditional methods such as high-temperature pyrolysis and chemical catalysis, the plasma technology has the characteristics of high degradation rate, high energy efficiency and easy operation.

At present, there have been related studies on use of a cold plasma technology to degrade $SF_6$. For example, Shih et al. adopted a radio frequency plasma method and proposed a low-concentration $SF_6$ waste gas treatment device that can be applied to cascade etching equipment in the semiconductor industry. Kabouzi et al. studied changes in the degradation rate of $SF_6$ under different concentration ranges and different microwave powers. Zhang Xiaoxing et al. studied the effect rule of different active gases and filling media on the degradation rate of $SF_6$ in dielectric barrier discharge.

However, at present, these cold plasma methods can only achieve a high degradation rate during treatment of low-concentration $SF_6$ waste gas. When high-concentration $SF_6$ waste gas actually generated in the power industry is treated, the waste gas needs to be diluted before degradation. Moreover, cold plasma has low treatment capability of degrading $SF_6$, and a gas flow rate is usually not higher than 1 L/min, which is far from enough in industrial applications. In addition, $SF_6$ molecules cannot be completely decomposed due to low discharge power of the cold plasma, and toxic sulfur oxyfluorides will be produced, which is unfavorable for exhaust gas treatment. The present invention aims to solve the above problems.

Some prior arts can be seen from the documents US 5965786 A, US 2002/070669 A1, EP 3821969 A1, US 2007/235339 A1.

The above-mentioned information disclosed in the background is only for enhancing the understanding of the background of the present invention, and therefore may contain information that does not form the prior art that is well-known to a person of ordinary skill in the art in this country.

## SUMMARY

For the problems in the prior art, the present invention provides a sulfur hexafluoride (SF6) degrading device based on thermal plasma. The treatment capability is improved by using thermal plasma, and self-recovery of $SF_6$ is inhibited by using a hydrogen-containing reaction gas to increase a degradation rate; $SF_6$ molecules are thoroughly decomposed, and meanwhile, obtained degradation products are subjected to harmless treatment. The $SF_6$ degrading device based on the thermal plasma has an extremely good practical value.

The present invention is defined in the appended claims.

As an example, a SF6 degrading device based on thermal plasma includes:
a gas inlet control system which includes:

a carrier gas Ar input line including a carrier gas Ar source, a first gas valve and a first mass flow meter which are connected in sequence;
a reaction gas input line, wherein a reaction gas may be $H_2$, and the reaction gas input line includes a reaction gas $H_2$ source, a second gas valve and a second mass flow meter which are connected in sequence;
a $SF_6$ gas input line including a $SF_6$ gas source, a third gas valve, a vacuum pump and a third mass flow meter which are connected in sequence;
a thermal plasma generator which includes:

a closed shell including a circulating water cooling interlayer and a reaction cavity enclosed by the water cooling interlayer, wherein the reaction cavity communicates with the gas inlet control system to respectively receive a carrier gas Ar, a reaction gas $H_2$ and $SF_6$ according to a predetermined ratio through three swirlers;

three annular electrodes which are respectively a cathode, an arc strike anode and an arcing anode and are electrically connected to a direct current power supply to generate a thermal plasma jet flow, wherein the three swirlers are respectively clung to the three annular electrodes;

a harmless treatment system which includes:

a sulfur powder filtering device communicating with the reaction cavity to filter out sulfur powder in mixed gas from the reaction cavity;

an alkali liquid spraying tower communicating with the sulfur powder filtering device and including a mortar pump for cyclically pumping alkali liquid to form a spray;

a waste gas detection device communicating with the alkali liquid spraying tower to sample and detect waste gas discharged from the alkali liquid spraying tower.

In the $SF_6$ degrading device based on the thermal plasma, the carrier gas Ar has a flow rate of 30 L/min; when the reaction gas is hydrogen, $H_2$ has a flow rate of 40 L/min; and $SF_6$ has a flow rate of 10 L/min.

In the $SF_6$ degrading device based on the thermal plasma, a negative electrode of the direct current power supply is connected to the cathode; a positive electrode of the direct current power supply is connected to the arc strike anode and the arcing anode; the direct current power supply generates an overvoltage for arc striking; after arcing, a constant current is provided; and the direct current power supply has an adjustable output power.

In the $SF_6$ degrading device based on the thermal plasma, a working voltage of the direct current power supply is 150 V, and a working current of the direct current power supply is 100 A.

In the $SF_6$ degrading device based on the thermal plasma, each swirler internally includes a rotating gas path, so that a gas flow field of input gas converges towards a center of the corresponding annular electrode.

In the $SF_6$ degrading device based on the thermal plasma, the water cooling interlayer adopts a split type once-through water cooling structure; a surface of a water path is provided with a concave-convex structure to enlarge a heat exchange area; the device is cooled by using a circulating water source, which is driven by a water pump; and the water pump has a lift of 45 m.

In the $SF_6$ degrading device based on the thermal plasma, the alkali liquid spraying tower is provided with a stainless steel pore plate used for placing a polyethylene (PE) plastic fragment packing.

In the $SF_6$ degrading device based on the thermal plasma, the alkali liquid spraying tower uses 5% $Ca(OH)_2$ alkali liquid.

In the $SF_6$ degrading device based on the thermal plasma, the waste gas detection device includes an X-ray diffraction analyzer, a chromatographic analyzer and a spectrum analyzer.

In the $SF_6$ degrading device based on the thermal plasma, within the predetermined ratio, a flow rate ratio of $H_2$ to $SF_6$ is greater than 3.

Compared with the prior art, the present invention has the following advantages: the $SF_6$ input gas path of the present invention can directly pump gas in retired equipment through a vacuum pump, so that automatic gas inlet control is achieved under the assistance of the mass flow meters; meanwhile, with collection and detection devices for sulfur powder, waste gas and waste residues, harmless treatment of degradation products is achieved; the degradation rate of the input $SF_6$ can be up to 99% or above; under the condition of ensuring the degradation rate, the flow rate of treated $SF_6$ can reach 10-15 L/min, approximately 5 kg/h; and the energy efficiency is high, and about 300 g of $SF_6$ gas can be treated per 1 kwh of electric energy.

## BRIEF DESCRIPTION OF THE DRAWINGS

By reading the detailed description in the preferred specific implementation modes below, various other advantages and benefits of the present invention will become clear to those of ordinary skill in the art. The accompanying drawings in the description are only used for the purpose of illustrating the preferred implementation modes, and are not considered as a limitation to the present invention. Obviously, the drawings described below are only some embodiments of the present invention. Furthermore, throughout the drawings, the same reference signs are used to denote the same components.

In the drawings:

Fig. 1 is a schematic system diagram of a $SF_6$ degrading device based on thermal plasma according to one embodiment of the present invention;

Fig. 2 is a schematic structural diagram of a $SF_6$ degrading device based on thermal plasma according to one embodiment of the present invention;

Fig. 3 is a schematic front view of a swirler of a $SF_6$ degrading device based on thermal plasma according to one embodiment of the present invention;

Fig. 4 is a schematic top view of a swirler of a $SF_6$ degrading device based on thermal plasma according to one embodiment of the present invention;

Fig. 5 is a schematic sectional view of a water cooling interlayer of a $SF_6$ degrading device based on thermal plasma according to one embodiment of the present invention; and

Fig. 6 is a schematic diagram of a reaction principle of a thermal plasma treatment method for $SF_6$ degradation according to one embodiment of the present invention.

The present invention is further explained below in combination with the accompanying drawings and the embodiments.

## DETAILED DESCRIPTION

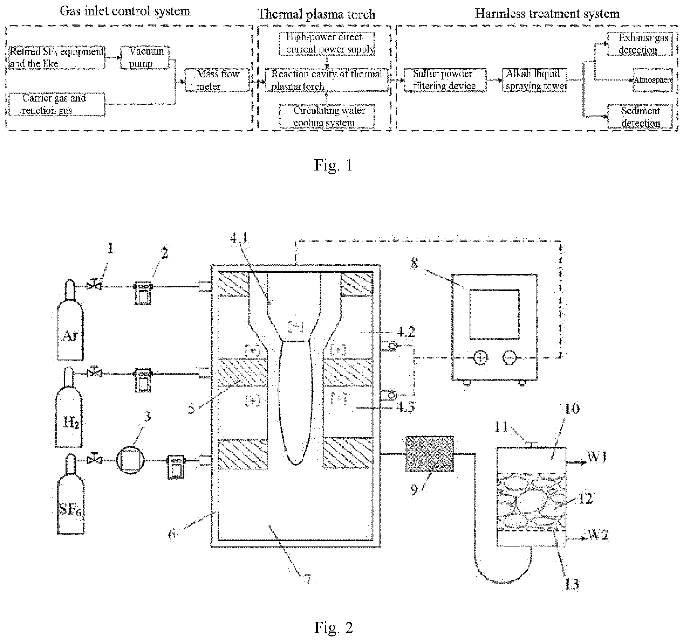

Specific embodiments of the present invention will be described in more detail below with reference to Fig. 1 to Fig. 6. Although specific embodiments of the present invention are shown in the drawings, it should be understood that the present invention can be implemented in various forms and should not be limited by the embodiments set forth herein. On the contrary, these embodiments are provided to enable a more thorough understanding of the present invention and to fully deliver the scope of the present invention to those skilled in the art.

It should be noted that certain words are used in the specification and claims to refer to specific components. Those skilled in the art should understand that they may use different terms to refer to a same component. This specification and claims do not use differences in terms as a way to distinguish components, but use differences in functions of components as a criterion for distinguishing. If "comprise" or "include" mentioned in the entire specification and claims is an open term, it should be interpreted as "including but not limited to". The following description of the specification is a preferred implementation mode for implementing the present invention. However, the description is based on the general principles of the specification and is not intended to limit the scope of the present invention. The protection scope of the present invention shall be subject to those defined by the appended claims.

In order to facilitate the understanding of the embodiments of the present invention, specific embodiments will be used as an example for further explanation and description in conjunction with the accompanying drawings, and the drawings do not constitute a limitation to the embodiments of the present invention.

For better understanding, as shown in Fig. 1 to Fig. 6, a $SF_6$ degrading device based on thermal plasma includes: a gas inlet control system which includes:

a carrier gas Ar input line including a carrier gas Ar source, a first gas valve 1 and a first mass flow meter 2 which are connected in sequence;

a reaction gas $H_2$ input line including a reaction gas $H_2$ source, a second gas valve and a second mass flow meter which are connected in sequence;

a $SF_6$ gas input line including a $SF_6$ gas source, a third gas valve, a vacuum pump 3 and a third mass flow meter which are connected in sequence;

a thermal plasma generator which includes:

a closed shell including a circulating water cooling interlayer 6 and a reaction cavity 7 enclosed by the water cooling interlayer 6, wherein the reaction cavity 7 communicates with the gas inlet control system to respectively receive a carrier gas Ar, a reaction gas $H_2$ and $SF_6$ according to a predetermined ratio through swirlers 5;

annular electrodes which are respectively a cathode 4.1, an arc strike anode 4.2 and an arcing anode 4.3, and are electrically connected to a direct current power supply 8 respectively to generate a thermal plasma jet flow, wherein the arc strike anode 4.2 also achieves effects of increasing an arc length and increasing an arc voltage to achieve high-power outputting at a low current; there are three swirlers 5, which are all made of a polytetrafluoroethylene material and are respectively clung to the three annular electrodes; the swirlers can resist HF corrosion and play an insulation role between the electrodes;

a harmless treatment system which includes:

a sulfur powder filtering device 9 communicating with the reaction cavity 7 to filter out sulfur powder in mixed gas from the reaction cavity 7;

an alkali liquid spraying tower 10 communicating with the sulfur powder filtering device 9 and including a mortar pump for cyclically pumping alkali liquid to form a spray;

a waste gas detection device communicating with the alkali liquid spraying tower 10 to sample and detect waste gas discharged from the alkali liquid spraying tower 10.

In a preferable embodiment of the $SF_6$ degrading device based on the thermal plasma, the carrier gas Ar has a flow rate of 30 L/min; the reaction gas $H_2$ has a flow rate of 40 L/min; and $SF_6$ has a flow rate of 10 L/min.

In a preferable embodiment of the $SF_6$ degrading device based on the thermal plasma, a negative electrode and a positive electrode of the direct current power supply 8 are respectively connected to the annular electrodes to first generate an overvoltage between the cathode 4.1 and the arc strike anode 4.2 for arc striking; after arcing, a constant current is provided between the cathode 4.1 and the arcing anode 4.3; and the direct current power supply 8 has an adjustable output power.

In a preferable embodiment of the $SF_6$ degrading device based on the thermal plasma, a working voltage of the direct current power supply 8 is 150 V, and a working current of the direct current power supply is 100 A.

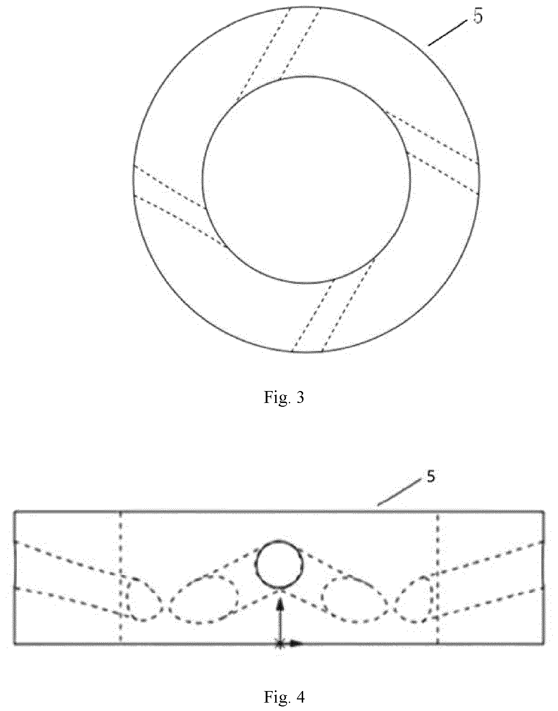

In a preferable embodiment of the $SF_6$ degrading device based on the thermal plasma, each swirler 5 internally includes a rotating gas path, as shown in Fig. 3, so that a gas flow field of input gas converges towards a center of the corresponding annular electrode.

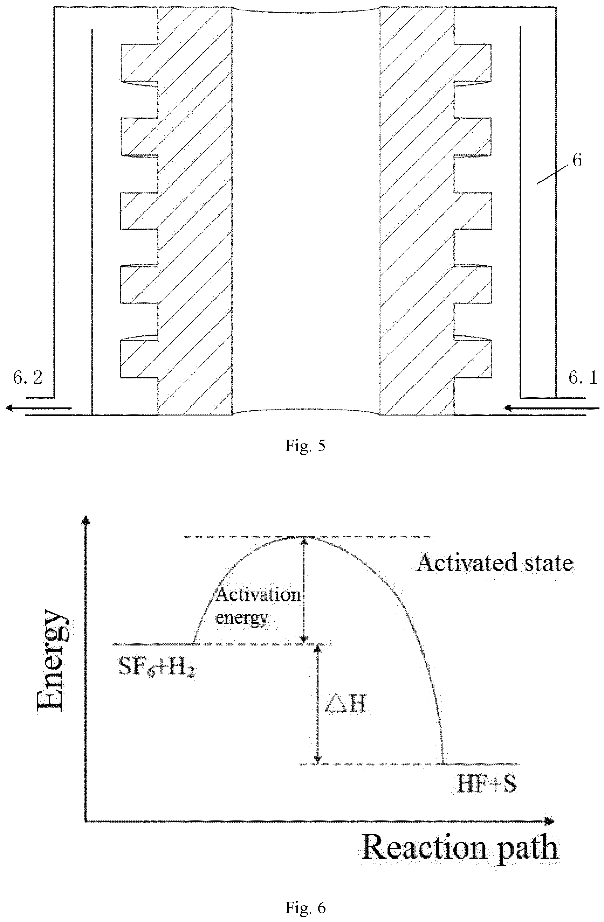

In a preferable embodiment of the $SF_6$ degrading device based on the thermal plasma, the water cooling interlayer 6 adopts a split type once-through water cooling structure; a surface of a water path is provided with a concave-convex structure to enlarge a heat exchange area, as shown in Fig. 5; the device is cooled by using a circulating water source; cooling water first enters the device from a water inlet 6.1 to be in full contact with the electrodes and quickly bring away thermal loads on the electrodes; after passing through a flow guide plate, the cooling water is drained from a water outlet 6.2; the cooling is driven by a water pump; and the water pump has a lift of 45 m.

In a preferable embodiment of the $SF_6$ degrading device based on the thermal plasma, the alkali liquid spraying tower 10 is provided with a stainless steel pore plate used for placing a PE plastic fragment packing.

In a preferable embodiment of the $SF_6$ degrading device based on the thermal plasma, the alkali liquid spraying tower 10 uses 5% $Ca(OH)_2$ alkali liquid.

In a preferable embodiment of the $SF_6$ degrading device based on the thermal plasma, the waste gas detection device includes an X-ray diffraction analyzer, a chromatographic analyzer and a spectrum analyzer.

In a preferable embodiment of the $SF_6$ degrading device based on the thermal plasma, within the predetermined ratio, a flow rate ratio of $H_2$ to $SF_6$ is greater than 3.

In one embodiment, the $SF_6$ degrading device based on the thermal plasma includes a gas inlet control system, a thermal plasma generator and a harmless treatment system. The gas inlet control system includes input lines for three gases: $SF_6$, a carrier gas and a reaction gas; each gas input line includes a gas source, a gas valve and a mass flow meter; the mass flow meters control the flow rates of the three gases to be adjustable; a typical working state is as follows: the carrier gas Ar has a flow rate of 30 L/min; the reaction gas $H_2$ has a flow rate of 40 L/min; and $SF_6$ has a flow rate of 10 L/min. In addition, there is a vacuum pump 3 between the $SF_6$ gas source and the mass flow meter, and the vacuum pump 3 can be used for directly pumping gas in equipment such as a retired $SF_6$ circuit breaker for degradation.

In one embodiment, the thermal plasma generator includes a direct current power supply 8, a reaction cavity 7 and a circulating water cooling system; a negative electrode and a positive electrode of the high-power direct current power supply 8 are respectively connected to a cathode and anodes of the thermal plasma generator. During working, the direct current power supply 8 will first generate an overvoltage for arc striking; after arcing, a stable current is then provided; and the power supply has an adjustable output power. A typical working state is at a voltage of 150 V and a current of 100 A. The reaction cavity 7 is used for accommodating the thermal plasma jet flow generated by discharge and degrading input $SF_6$ here. A wall of the reaction cavity 7 adopts a high-temperature-resistant and corrosion-resistant material, and the reaction cavity is provided with a sulfur powder cleaning device; meanwhile, a front surface of the reaction cavity is provided with an observation window which is made of organic glass; the device is cooled by the circulating water cooling system using a circulating water source in a wall interlayer of the reaction cavity 7, and the cooling is driven by a water pump which has a lift of 45 m.

In one embodiment, the harmless treatment system includes a sulfur powder filtering device 9, an alkali liquid spraying tower 10, a waste gas detection device and a waste residue detection device. The sulfur powder filtering device 9 uses a bag collector, which requires the device to be sealed as a whole; and sulfur powder collected at the bottom can be recycled. The alkali liquid spraying tower 10 uses 5% $Ca(OH)_2$ alkali liquid, and a mortar pump is used to cyclically pump alkali liquid into air to form two layers of sprays which are in full contact with and absorb acidic exhaust gas to finally achieve a discharge standard. $CaF_2$ sediments collected at the bottom can be recycled. The waste gas detection device can adopt a chromatographic analyzer and a spectrum analyzer. After waste gas is discharged from the alkali liquid spraying tower 10, a sampling bag is used to collect the waste gas and the waste gas is detected. After it is detected that the waste gas meets the standard, the waste gas can be directly discharged into the atmosphere. The waste residue detection device can use an X-ray diffraction analyzer. Waste residues collected at the bottom of the alkali liquid spraying tower 10 need to be detected. The waste residues are treated after it is confirmed that no nontoxic byproducts are contained.

In one embodiment, electrodes of the plasma generator are annular electrodes which are made of copper tungsten and are respectively clung to the three swirlers 5 to achieve electrical insulation. Each swirler 5 internally includes a rotating gas path, so that a gas flow field of input gas converges towards a center of the corresponding electrode, so that arcing is kept in the center of the electrode to reduce ablation, and a stable thermal plasma jet flow is generated.

The reaction cavity 7 is used for accommodating the thermal plasma jet flow generated by discharge and degrading input $SF_6$ here. The reaction cavity is made of stainless steel and is provided with a sulfur powder collection and cleaning device. The cavity can be opened to pull out a sulfur powder collection box. Meanwhile, a front surface of the reaction cavity 7 is provided with an observation window which is made of organic glass.

The harmless treatment system includes a sulfur powder filtering device 9, an alkali liquid spraying tower 10, a waste gas collection and detection outlet W1 and a waste residue collection and detection outlet W2.

The sulfur powder filtering device 9 uses a bag collector, which requires the device to be sealed as a whole, and sulfur powder collected at the bottom can be recycled.

Since $Ca(OH)_2$ can absorb HF and remove fluorine from waste liquid, the alkali liquid spraying tower 10 uses 5% $Ca(OH)_2$ alkali liquid which is added from a feed port 11; and a stainless steel pore plate 13 is added in the alkali liquid spraying tower 10 and is used for placing a PE fragment packing 12 to avoid production of large air bubbles in the alkali liquid. Exhaust gas is introduced from the bottom of an absorption tank and is in full contact with and absorbed by a $Ca(OH)_2$ suspension, so that the exhaust gas finally meets the discharge standard. $CaF_2$ sediments collected at the bottom can be recycled.

The waste gas collection and detection outlet W 1 can adopt a chromatographic analyzer and a spectrum analyzer. After waste gas is discharged from the alkali liquid spraying tower, a sampling bag is used to collect the waste gas and the waste gas is detected. After it is detected that the waste gas meets the standard, the waste gas can be directly discharged into the atmosphere. The waste residue collection and detection outlet W2 can use an X-ray diffraction analyzer. Waste residues collected at the bottom of the alkali liquid spraying tower 10 need to be detected. The waste residues are treated after it is confirmed that no nontoxic byproducts are contained.

The device in this example can work stably for a long time under an atmospheric pressure. In the implementation process, the water cooling system is first turned on to drive the circulating water source in the water cooling interlayer 6; and the gas valves, the vacuum pump and the mass flow meters are then turned on. After gas flow parameters are set, the thermal plasma generator is powered by the direct current power supply 8 to generate a thermal plasma jet flow; $SF_6$ reacts with $H_2$ in a high-temperature region and elemental S and HF gas are generated in the reaction cavity 7. The elemental S is removed by the sulfur powder filtering device 9, and the HF gas is removed by the alkali liquid spraying tower 10; the waste gas can be discharged after the finally obtained waste gas has been tested to meet the standard at the waste gas collection and detection outlet W1, and the waste residues can be discharged after waste residues have been tested to meet the standard at the waste residue collection and detection outlet W2.

When Ar serves as carrier gas, arcing is more stable, power required to maintain the discharge is low, and Ar is not bonded with H or F to generate byproducts. As a reaction gas, $H_2$ reacts with $SF_6$ to only generate HF and S, which is convenient for harmless treatment.

Optionally, $N_2$ can be used as the carrier gas, so that the raw material is cheaper and readily available. However, N radicals and F radicals will be bonded with each other in the cooling process to generate $NF_3$ which is a greenhouse gas.

Optionally, the reaction gas can be other hydrogen-containing gases, which can also provide H radicals and F radicals which are bonded to generate HF. However, when $CH_4$ and $NH_3$ are used as the reaction gas, byproducts such as $CF_4$ and $NF_3$ will be generated, which are also greenhouse gases.

Optionally, the reaction gas can be oxygen-containing gas. The principle of the oxygen-containing gas for degrading $SF_6$ is slightly different from that of hydrogen-containing gas. In the cooling process, instead of bonding with F radicals, O radicals are provided to be bonded with S to form a sulfur-oxygen double bonds, and $SO_2F_2$, $SOF_2$, $SOF_4$, $SO_2$ and other compounds are generated, thereby inhibiting the self-recovery characteristic of $SF_6$. When $O_2$ is used as the reaction gas, the advantage is that no solid products are generated, but the disadvantage is that harmful byproducts such as $SO_2F_2$ are generated. When $H_2O$ is used as the reaction gas, a main product is still HF, but harmful byproducts such as $SO_2F_2$ are also generated. Particularly, the simultaneous presence of HF and $H_2O$ is highly corrosive and will reduce the service life of the device.

More preferably, a flow rate ratio of introduced $H_2$ to $SF_6$ is slightly greater than 3, which can further improve the degrading effect of $SF_6$.

More preferably, the $SF_6$ treatment capability can be further improved by keeping a gas flow rate ratio and continuing to increase a total flow rate.

In one embodiment, a thermal plasma treatment method for $SF_6$ degradation by using the $SF_6$ degrading device based on the thermal plasma includes:

Ar is input into the thermal plasma generator as a carrier gas, and annular electrodes are electrically connected to a direct current power supply to generate an arc plasma region under the carrier gas Ar.

$SF_6$ and $H_2$ in a predetermined ratio which are to be reacted are input into the arc plasma region to generate hydrogen radicals and fluorine radicals which are bonded with each other to generate HF to inhibit the self-recovery reaction of $SF_6$, and final products include HF and elemental S. A reaction temperature in the arc plasma region is 6000K-15000K.

In a preferable implementation of the thermal plasma treatment method for $SF_6$ degradation, a sulfur powder filtering device communicates with the arc plasma region to filter out sulfur powder in mixed gas after the reaction in the arc plasma region. An alkali liquid spraying tower communicates with the sulfur powder filtering device and sprays acidic exhaust gas from the sulfur powder filtering device with alkali liquid.

In a preferable implementation of the thermal plasma treatment method for $SF_6$ degradation, the predetermined ratio of $H_2$ to $SF_6$ is 3:1 to 5:1.

In a preferable implementation of the thermal plasma treatment method for $SF_6$ degradation, the predetermined ratio of Ar: $H_2$: $SF_6$ is 30 L/min:40 L/min: 10 L/min.

In a preferable implementation of the thermal plasma treatment method for $SF_6$ degradation, Ar, $H_2$ and $SF_6$ are respectively introduced into the thermal plasma generator via swirlers.

In a preferable implementation of the thermal plasma treatment method for $SF_6$ degradation, the thermal plasma generator includes a circulating water cooling interlayer which communicates with a water cooling system to drive a circulating water source in the water cooling interlayer, so that cooling water is in full contact with electrodes and quickly brings away thermal loads on the electrodes.

In a preferable implementation of the thermal plasma treatment method for $SF_6$ degradation, the thermal plasma generator includes three annular electrodes. A high-voltage alternating voltage is applied between a cathode and an arc strike anode during discharge to strike an arc; after arcing succeeds, a stable direct current is applied between the cathode and an arcing anode to maintain the discharge of the thermal plasma generator. The arc strike anode also plays a role of increasing an arc length and increasing an arc voltage, so as to achieve high-power outputting at a low current.

In a preferable implementation of the thermal plasma treatment method for $SF_6$ degradation, a negative electrode and a positive electrode of the direct current power supply are respectively connected to the cathode and the anodes of the annular electrodes to first generate a high-voltage alternating voltage for arc striking; after arcing, a constant current is provided; and the direct current power supply has an adjustable output power.

In a preferable implementation of the thermal plasma treatment method for $SF_6$ degradation, a working voltage of the direct current power supply is 150 V, and a working current of the direct current power supply is 100 A.

In a preferable implementation of the thermal plasma treatment method for $SF_6$ degradation, the alkali liquid spraying tower uses 5% $Ca(OH)_2$ alkali liquid.

In one embodiment, the thermal plasma treatment method for $SF_6$ degradation has a treatment capability for $SF_6$ of 10 L/min or more.

In one embodiment, Ar is used as the carrier gas to generate a stable direct current arc under a working condition of the thermal plasma generator, and $SF_6$ and $H_2$ which are to be reacted are uniformly mixed and input through the swirlers; and a high temperature generated in the arc plasma region reaches a temperature for thoroughly decomposing the reaction gas, thus releasing a large number of hydrogen radicals and fluorine radicals. Since the bonding of the two radicals to generate HF has a smallest Gibbs free energy, most of the fluorine radicals are captured and no longer react with sulfur radicals to generate $SF_6$; and the final products after the reaction gas passes through the thermal plasma region include HF and elemental S. When the hydrogen is excessive, the degradation rate of $SF_6$ treated by this method can reach 99.6% or above, and the concentration of $SF_6$ in the exhaust gas can be less than 0.07%. A calculation method of the degradation rate is to divide a difference between the concentrations of input $SF_6$ and output $SF_6$ by the concentration of the input $SF_6$.

In one embodiment, the thermal plasma generator is powered by a high-power direct current power supply to generate a high-temperature arc plasma region by discharge; a reaction temperature in the arc plasma region can reach 6000K-15000K; the reaction temperature can also reach 3500K or more even if it is at a tail end of a thermal plasma jet flow outside an electric field region; and when the reaction temperature increases, the movement rate of gas molecules increases, which not only increases the number of collisions of the gas molecules within unit time. More importantly, the energy of the gas molecules increases, so that the percentage of activated molecules increases, thereby accelerating a $SF_6$ degradation reaction. The hydrogen-containing reaction gas includes $H_2$, $NH_3$, $CH_4$, $H_2S$, etc., generating H radicals which are bonded with F radicals released by $SF_6$ in the thermal plasma region to inhibit the self-recovery characteristic of $SF_6$; when the reaction temperature is sufficient high, assuming that all the gas molecules are decomposed into S, F, H radicals, since the generation of elemental S and HF has a lower Gibbs free energy than the self-recovery generation of $SF_6$ and $H_2$, the final products are more likely to be HF rather than $SF_6$ according to the principle of a minimum Gibbs free energy; and at the same time, according to a calculation result of Gibbs free energy change, when the reaction temperature is higher than 2534K, an activation energy required for complete degradation of $SF_6$ into S radicals and F radicals can be provided. The resulting overall reaction is as follows:

$$SF_6 + 3H_2 \rightarrow S + 6HF \quad \triangle H = -419.3 \text{ kJ/mol}, \ \triangle S = 697 \text{ J/(mol} \cdot \text{K)}$$

At this time, the numerical value of $\triangle H - T\triangle S$ is much less than 0, and the reaction can proceed rapidly and spontaneously. The reaction principle is as shown in Fig. 6. A optimal predetermined ratio of $H_2$ to $SF_6$ is 3:1, but in practical application, in order to ensure the degradation effect of $SF_6$, a $H_2$ ratio should be slightly excessive, and the predetermined ratio may be 4:1.

In one embodiment, regulation and control of a gas flow field have two main functions. One function is to generate a rotating gas flow through the swirlers, so that an arc root of the arc continuously moves on the surfaces of the electrodes to reduce local electrode ablation and prolong the service life of the electrodes. Meanwhile, multiple symmetrical rotating gas inlets make the reaction gas fully mixed to reduce the use amount of $H_2$ and improve the degradation effect of $SF_6$. The other function is to enable a gas flow to generate a downward velocity component through the swirlers, which can make the arcing more stable and concentrated and make the gas flow field of the input gas more converge to the high-temperature region in the center of the arc, so as to improve the degradation effect. Each swirler 5 includes four symmetrical clockwise rotating gas inlets, as shown in Fig. 4.

In one embodiment, the closed shell includes a reaction cavity 7 such as a pneumatic cooling expansion cavity and a water cooling interlayer 6. When a gas flow after $SF_6$ degradation enters the pneumatic cooling expansion cavity from a narrow reaction gas path, due to the sudden expansion of a gas volume, a flow velocity decreases rapidly, which achieves a cooling effect; and in combination with circulating water cooling heat exchange in the water cooling interlayer 6 on the cavity wall, rapid cooling of the reaction gas is achieved. The device in this example can work stably for a long time under an atmospheric pressure. In the implementation process, the device is characterized in that firstly, the water cooling system is turned on to drive the circulating water source in the water cooling interlayer 6; the reaction gas is then introduced from the swirler 5; the power supply of the thermal plasma generator is finally turned on to generate the thermal plasma jet flow; and $SF_6$ reacts with $H_2$ in the high-temperature region and elemental S and HF gas are generated. After the reaction ends, the power supply of the plasma generator is turned off first; the three gas inlets are then closed; and the cooling water source is turned off at last. In this example, when the hydrogen is excessive, the degradation rate of $SF_6$ can reach 99.6% or above, and the concentration of $SF_6$ in the exhaust gas can be less than 0.07%. The calculation method of the degradation rate is to divide a difference between the concentrations of input $SF_6$ and output $SF_6$ by the concentration of the input $SF_6$. In addition, in this example, the $SF_6$ treatment capability can reach 10 L/min or more.

Optionally, the carrier gas can be replaced by gas such as $N_2$, and the reaction gas can be replaced by hydrogen-containing gas such as $CH_4$, $NH_3$ and $H_2S$, or $O_2$.

Optionally, the three-annular-electrode structure can be replaced by a double-electrode structure, but the double-electrode structure will lead to narrowing of the thermal plasma region and put forward higher requirements on the power supply of the thermal plasma generator.

Optionally, the three gas inlets can be replaced by two gas inlets or a single gas inlet, which can make the reaction gas mixed more uniformly, but also lead to problems such as the adhesion of sulfur powder on the surface of the electrode to reduce the service life of the electrode.

More preferably, an electrode material can be replaced by a material with better conductivity and higher corrosion resistance, such as silver tungsten.

More preferably, the material of the reaction cavity of the thermal plasma generator is replaced by Hastelloy C-2000, which is more resistant to HF gas corrosion than ordinary stainless steel.

Although the embodiments of the present invention are described above with reference to the accompanying drawings, the present invention is not limited to the above specific embodiments and application fields. The above specific embodiments are only illustrative and instructive, but not restrictive.

## Claims

1. A sulfur hexafluoride ($SF_6$) degrading device based on thermal plasma, comprising
   a gas inlet control system which comprises:

   a carrier gas Ar input line comprising a carrier gas Ar source, a first gas valve and a first mass flow meter;
   a reaction gas input line comprising a reaction gas source, a second gas valve and a second mass flow meter;
   a $SF_6$ gas input line comprising a $SF_6$ gas source, a third gas valve, a vacuum pump and a third mass flow meter;
   a thermal plasma generator which comprises:

   a closed shell comprising a circulating water cooling interlayer (6) and a reaction cavity (7) enclosed by the water cooling interlayer (6), wherein the reaction cavity (7) is connected to the gas inlet control system, so as to receive a carrier gas Ar, a reaction gas and $SF_6$ according to a predetermined ratio through three swirlers (5) respectively, wherein the reaction gas is a hydrogen-containing gas or an oxygen-containing gas;
   three annular electrodes which are respectively a cathode (4.1), an arc strike anode (4.2) and an arcing anode (4.3) and are electrically connected to a direct current power supply (8) to generate a thermal plasma jet flow;

a harmless treatment system which is connected to the reaction cavity and is configured to treat solid product and gas product,
whereby the harmless treatment system includes:

a sulfur powder filtering device (9) communicating with the reaction cavity to filter out sulfur powder in mixed gas from the reaction cavity;
an alkali liquid spraying tower (10) communicating with the sulfur powder filtering device (9) and including a mortar pump for cyclically pumping alkali liquid to form a spray;
a waste gas detection device communicating with the alkali liquid spraying tower to sample and detect waste gas discharged from the alkali liquid spraying tower.

2. The $SF_6$ degrading device based on the thermal plasma according to claim 1, wherein the device is configured such that the carrier gas Ar has a flow rate of 30 L/min; when the reaction gas is hydrogen, $H_2$ has a flow rate of 40 L/min; and $SF_6$ has a flow rate of 10 L/min.

3. The $SF_6$ degrading device based on the thermal plasma according to claim 1, wherein a negative electrode of the direct current power supply (8) is connected to the cathode (4.1); a positive electrode of the direct current power supply (8) is connected to the arc strike anode (4.2) and the arcing anode (4.3); the direct current power supply (8) generates an overvoltage for arc striking; after arcing, a constant current is provided; and the direct current power supply (8) has an adjustable output power.

4. The $SF_6$ degrading device based on the thermal plasma according to claim 1, wherein the device is configured such that a working voltage of the direct current power supply (8) is 150 V, and a working current of the direct current power supply (8) is 100 A.

5. The $SF_6$ degrading device based on the thermal plasma according to claim 1, wherein each swirler (5) comprises a rotating gas path, so that a gas flow field of input gas converges towards a center of the corresponding annular electrode.

6. The $SF_6$ degrading device based on the thermal plasma according to claim 1, wherein the water cooling interlayer (6) adopts a once-through water cooling structure; a surface of a water path is provided with a concave-convex structure to enlarge a heat exchange area; the device is cooled by using a circulating water source, which is driven by a water pump.

7. The $SF_6$ degrading device based on the thermal plasma according to claim 1, wherein the alkali liquid spraying tower (10) is provided with a stainless steel pore plate used for placing a polyethylene (PE) plastic fragment packing.

8. The $SF_6$ degrading device based on the thermal plasma according to claim 7, wherein the device is configured such that the alkali liquid spraying tower (10) uses 5% $Ca(OH)_2$ alkali liquid to absorb an acidic gas product.

9. The $SF_6$ degrading device based on the thermal plasma according to claim 1, wherein the waste gas detection device comprises an X-ray diffraction analyzer, a chromatographic analyzer and a spectrum analyzer.

10. The $SF_6$ degrading device based on the thermal plasma according to claim 2, wherein the device is configured such that within the predetermined ratio, when the reaction gas is hydrogen, an actual flow rate ratio of $H_2$ to $SF_6$ is greater than 3 and less than 5.

**Patentansprüche**

1. Schwefelhexafluorid($SF_6$-)Abbauvorrichtung auf Basis von thermischem Plasma, umfassend
ein Gaseinlasssteuersystem, das Folgendes umfasst:

eine Trägergas-Ar-Eingangsleitung, die eine Trägergas-Ar-Quelle, ein erstes Gasventil und einen ersten Massendurchflussmesser umfasst;
eine Reaktionsgaseingangsleitung, die eine Reaktionsgasquelle, ein zweites Gasventil und einen zweiten Massendurchflussmesser umfasst;
eine $SF_6$-Gaseingangsleitung, die eine $SF_6$-Gasquelle, ein drittes Gasventil, eine Vakuumpumpe und einen dritten Massendurchflussmesser umfasst;
einen thermischen Plasmagenerator, der Folgendes umfasst:

eine geschlossene Hülle, die eine zirkulierende Wasserkühlungszwischenschicht (6) und einen Reaktionshohlraum (7) umfasst, der durch die Wasserkühlungszwischenschicht (6) umschlossen ist, wobei der Reaktionshohlraum (7) mit dem Gaseinlasssteuersystem verbunden ist, um jeweils ein Trägergas Ar, ein Reaktionsgas und $SF_6$ gemäß einem vorbestimmten Verhältnis durch drei Verwirbler (5) aufzunehmen, wobei das Reaktionsgas ein wasserstoffhaltiges Gas oder ein sauerstoffhaltiges Gas ist;
drei ringförmige Elektroden, die jeweils eine Kathode (4.1), eine Lichtbogenzündanode (4.2) und eine Lichtbogenanode (4.3) sind und elektrisch mit einer Gleichstromleistungsversorgung (8) verbunden sind, um einen thermischen Plasmastrahlfluss zu erzeugen;
ein unschädliches Behandlungssystem, das mit dem Reaktionshohlraum verbunden ist und konfiguriert ist, um Festprodukt und Gasprodukt zu behandeln,
wobei das unschädliche Behandlungssystem Folgendes beinhaltet:

eine Schwefelpulverfiltervorrichtung (9), die mit dem Reaktionshohlraum kommuniziert, um Schwefelpulver in Mischgas aus dem Reaktionshohlraum herauszufiltern;
einen Alkaliflüssigkeitssprühturm (10), der mit der Schwefelpulverfiltervorrichtung (9) kommuniziert und eine Mörtelpumpe zum zyklischen Pumpen von Alkaliflüssigkeit beinhaltet, um ein Spray zu bilden;
eine Abgaserfassungsvorrichtung, die mit dem Alkaliflüssigkeitssprühturm kommuniziert, um Abgas, das aus dem Alkaliflüssigkeitssprühturm abgelassen wird, zu beproben und zu erfassen.

2. $SF_6$-Abbauvorrichtung auf Basis von dem thermischen Plasma nach Anspruch 1, wobei die Vorrichtung konfiguriert ist, sodass das Trägergas Ar eine Durchflussrate von 30 l/min aufweist; wenn das Reaktionsgas Wasserstoff ist, $H_2$ eine Durchflussrate von 40 l/min aufweist; und $SF_6$ eine Durchflussrate von 10 l/min aufweist.

3. $SF_6$-Abbauvorrichtung auf Basis von dem thermischen Plasma nach Anspruch 1, wobei eine negative Elektrode der Gleichstromleistungsversorgung (8) mit der Kathode (4.1) verbunden ist; eine positive Elektrode der Gleichstromleistungsversorgung (8) mit der Lichtbogenzündanode (4.2) und der Lichtbogenanode (4.3) verbunden ist; die Gleichstromleistungsversorgung (8) eine Überspannung zum Lichtbogenzünden erzeugt; nach der Lichtbogenbildung ein konstanter Strom bereitgestellt ist; und die Gleichstromleistungsversorgung (8) eine einstellbare Aus-gangsleistung aufweist.

4. $SF_6$-Abbauvorrichtung auf Basis von dem thermischen Plasma nach Anspruch 1, wobei die Vorrichtung konfiguriert ist, sodass eine Arbeitsspannung der Gleichstromleistungsversorgung (8) 150 V ist und ein Arbeitsstrom der Gleichstromleistungsversorgung (8) 100 A ist.

5. $SF_6$-Abbauvorrichtung auf Basis von dem thermischen Plasma nach Anspruch 1, wobei jeder Verwirbler (5) einen rotierenden Gasweg umfasst, sodass ein Gasdurchflussfeld von Eingangsgas zu einem Zentrum der entsprechenden ringförmigen Elektrode konvergiert.

6. $SF_6$-Abbauvorrichtung auf Basis von dem thermischen Plasma nach Anspruch 1, wobei die Wasserkühlungszwischenschicht (6) eine Durchlaufwasserkühlungsstruktur annimmt; eine Oberfläche eines Wasserweges mit einer konkav-konvexen Struktur bereitgestellt ist, um eine Wärmeaustauschfläche zu vergrößern; die Vorrichtung durch Verwenden einer zirkulierenden Wasserquelle gekühlt wird, die durch eine Wasserpumpe angetrieben wird.

7. $SF_6$-Abbauvorrichtung auf Basis von dem thermischen Plasma nach Anspruch 1, wobei der Alkaliflüssigkeitssprühturm (10) mit einer Edelstahlporenplatte bereitgestellt ist, die zum Platzieren einer Polyethylen(PE-)Kunststofffrag-mentpackung verwendet wird.

8. $SF_6$-Abbauvorrichtung auf Basis von dem thermischen Plasma nach Anspruch 7, wobei die Vorrichtung konfiguriert ist, sodass der Alkaliflüssigkeitssprühturm (10) 5 % $Ca(OH)_2$-Alkaliflüssigkeit verwendet, um ein saures Gasprodukt zu absorbieren.

9. $SF_6$-Abbauvorrichtung auf Basis von dem thermischen Plasma nach Anspruch 1, wobei die Abgaserfassungsvorrichtung einen Röntgenbeugungsanalysator, einen chromatographischen Analysator und einen Spektrumanalysator umfasst.

**10.** SF$_6$-Abbauvorrichtung auf Basis von dem thermischen Plasma nach Anspruch 2, wobei die Vorrichtung konfiguriert ist, sodass innerhalb des vorbestimmten Verhältnisses, wenn das Reaktionsgas Wasserstoff ist, ein tatsächliches Durchflussratenverhältnis von H$_2$ zu SF$_6$ größer als 3 und weniger als 5 ist.

**Revendications**

**1.** Dispositif de dégradation de l'hexafluorure de soufre (SF$_6$) basé sur un plasma thermique, comprenant un système de commande d'entrée de gaz qui comprend :

une conduite d'entrée de gaz porteur Ar comprenant une source de gaz porteur Ar, une première vanne de gaz et un premier débitmètre massique ;
une conduite d'entrée de gaz de réaction comprenant une source de gaz de réaction, une deuxième vanne de gaz et un deuxième débitmètre massique ;
une conduite d'entrée de gaz SF$_6$ comprenant une source de gaz SF$_6$, une troisième vanne de gaz, une pompe à vide et un troisième débitmètre massique ;
un générateur de plasma thermique qui comprend :

une enveloppe fermée comprenant une couche intermédiaire de refroidissement d'eau de circulation (6) et une cavité de réaction (7) enfermée par la couche intermédiaire de refroidissement d'eau (6), dans laquelle la cavité de réaction (7) est reliée au système de commande d'entrée de gaz, de manière à recevoir un gaz porteur Ar, un gaz de réaction et SF$_6$ selon un rapport prédéterminé à travers trois coupelles de turbulence (5) respectivement, le gaz de réaction étant un gaz contenant de l'hydrogène ou un gaz contenant de l'oxygène ;
trois électrodes annulaires qui sont respectivement une cathode (4.1), une anode de coup d'arc (4.2) et une anode de production d'arc (4.3) et sont connectées électriquement à une alimentation électrique en courant continu (8) pour générer un flux de jet de plasma thermique ;
un système de traitement sans danger qui est relié à la cavité de réaction et est configuré pour traiter le produit solide et le produit gazeux,
le système de traitement sans danger comprenant :

un dispositif de filtration de poudre de soufre (9) communiquant avec la cavité de réaction pour éliminer de la cavité de réaction la poudre de soufre contenue dans le gaz mélangé ;
une tour de pulvérisation de liquide alcalin (10) communiquant avec le dispositif de filtration de poudre de soufre (9) et comprenant une pompe à mortier pour pomper cycliquement le liquide alcalin afin de former un jet pulvérisé ;
un dispositif de détection de gaz résiduaire communiquant avec la tour de pulvérisation de liquide alcalin pour échantillonner et détecter le gaz résiduaire déchargé de la tour de pulvérisation de liquide alcalin.

**2.** Dispositif de dégradation du SF$_6$ basé sur le plasma thermique selon la revendication 1, le dispositif étant configuré de telle sorte que : le gaz porteur Ar comporte un débit de 30 L/min ; quand le gaz de réaction est l'hydrogène, H$_2$ comporte un débit de 40 L/min ; et SF$_6$ comporte un débit de 10 L/min.

**3.** Dispositif de dégradation du SF$_6$ basé sur le plasma thermique selon la revendication 1, dans lequel une électrode négative de l'alimentation électrique en courant continu (8) est connectée à la cathode (4.1) ; une électrode positive de l'alimentation électrique en courant continu (8) est connectée à l'anode de coup d'arc (4.2) et à l'anode de production d'arc (4.3) ; l'alimentation électrique en courant continu (8) produit une surtension pour le coup d'arc ; après la production d'arc, un courant constant est fourni ; et l'alimentation électrique en courant continu (8) comporte une puissance de sortie réglable.

**4.** Dispositif de dégradation du SF$_6$ basé sur le plasma thermique selon la revendication 1, le dispositif étant configuré de telle sorte qu'une tension de fonctionnement de l'alimentation électrique en courant continu (8) soit 150 V, et qu'une intensité de fonctionnement de l'alimentation électrique en courant continu (8) soit 100 A.

**5.** Dispositif de dégradation du SF$_6$ basé sur le plasma thermique selon la revendication 1, dans lequel chaque coupelle de turbulence (5) comprend un chemin de gaz rotatif, de sorte qu'un champ de d'écoulement de gaz du gaz d'entrée converge vers un centre de l'électrode annulaire correspondante.

**6.** Dispositif de dégradation du SF$_6$ basé sur le plasma thermique selon la revendication 1, dans lequel la couche intermédiaire de refroidissement d'eau (6) adopte une structure de refroidissement d'eau à un seul passage ; une surface d'un chemin d'eau est dotée d'une structure concave-convexe pour agrandir la superficie d'échange de chaleur ; le dispositif est refroidi au moyen d'une source d'eau de circulation qui est entraînée par une pompe à eau.

7. Dispositif de dégradation du $SF_6$ basé sur le plasma thermique selon la revendication 1, dans lequel la tour de pulvérisation de liquide alcalin (10) est munie d'une plaque à pores en acier inoxydable utilisée pour le placement d'une garniture en fragments de plastique polyéthylène (PE).

8. Dispositif de dégradation du $SF_6$ basé sur le plasma thermique selon la revendication 7, le dispositif étant configuré de telle sorte que la tour de pulvérisation de liquide alcalin (10) utilise 5 % de liquide alcalin $Ca(OH)_2$ pour absorber un produit gazeux acide.

9. Dispositif de dégradation du $SF_6$ basé sur le plasma thermique selon la revendication 1, dans lequel le dispositif de détection de gaz résiduaire comprend un analyseur à diffraction des rayons X, un analyseur chromatographique et un analyseur de spectre.

10. Dispositif de dégradation du $SF_6$ basé sur le plasma thermique selon la revendication 2, le dispositif étant configuré de telle sorte que, dans le rapport prédéterminé, quand le gaz de réaction est l'hydrogène, un rapport de débit effectif du $H_2$ au $SF_6$ est supérieur à 3 et inférieur à 5.

Gas inlet control system                    Thermal plasma torch                    Harmless treatment system

Fig. 1

Fig. 2

Fig. 3

Fig. 4

Fig. 5

Fig. 6

**EP 4 292 693 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5965786 A
- US 2002070669 A1
- EP 3821969 A1
- US 2007235339 A1